# FASCICULE DE BREVET EUROPEEN

(11) **EP 2 776 956 B1**
(45) Date de publication et mention de la délivrance du brevet: **23.04.2025**
(21) Numéro de dépôt: 12781122.2
(22) Date de dépôt: 07.11.2012
(51) Int. Cl.: G06F 30/13, G06F 30/20, G05B 15/02, E06B 9/68

(54) **PROCÉDÉ DE CONFIGURATION ET DE FONCTIONNEMENT D'UNE INSTALLATION DE PROTECTION SOLAIRE DANS UN BÂTIMENT**
VERFAHREN FÜR KONFIGURATION UND BETRIEB EINER SONNENSCHUTZANLAGE EINES GEBÄUDES
METHOD OF CONFIGURATION AND OPERATION OF A SUN PROTECTION SYSTEM OF A BUILDING

(30) Priorité: 07.11.2011 FR 1160133; 12.04.2012 FR 1253396
(43) Date de publication de la demande: 17.09.2014
(73) Titulaire: SOMFY ACTIVITES SA, 74300 Cluses (FR)
(72) Inventeur: BEAUJEU, Thierry, F-74970 Marignier (FR); NEUMAN, Serge, F-74600 Seynod (FR); ROUX, Morgan, F-74190 Passy (FR); CHERON, Eric, F-74440 Taninges (FR)
(74) Mandataire: Novaimo
(86) Numéro de dépôt international: PCT/EP2012/072042
(87) Numéro de publication internationale: WO 2013/068408

(56) Documents cités:
- EP-A2- 2 357 544
- US-A- 4 457 296
- US-A1- 2006 207 730
- US-A1- 2010 071 856
- US-B2- 7 977 904

## Description

L'invention concerne le domaine du bâtiment et plus particulièrement des bâtiments à façades dites dynamiques, comportant des écrans motorisés de protection solaire, mobiles et ajustables, et des bâtiments dotés d'équipements électriques pour le confort et/ou la sécurité pilotables à distance.

Les façades dynamiques permettent d'assurer le confort lumineux dans le bâtiment et de réaliser des économies en énergie en régulant les flux énergétiques (apports thermiques et ventilation naturelle) à travers les ouvertures de la façade en combinaison avec le pilotage des équipements de chauffage, ventilation ou éclairage.

Les écrans peuvent être des stores d'intérieur, par exemple des stores vénitiens à lames orientables, ou des stores enroulables, ou des écrans extérieurs, des panneaux rigides orientables, etc. Plusieurs écrans peuvent être situés au niveau d'une même ouverture.

Des actionneurs pilotent le fonctionnement des équipements électriques, par exemple le mouvement en rotation et/ou en translation des écrans mobiles équipant les ouvertures, ou les paramètres des équipements d'éclairage, chauffage ou ventilation. Les actionneurs sont gérés de manière centrale au niveau de la pièce, de l'étage, de la façade à laquelle ils appartiennent ou simplement au niveau du bâtiment. Une unité de commande récupère également un certain nombre d'informations auprès de divers capteurs positionnés à l'intérieur et à l'extérieur du bâtiment (capteurs de présence, de température, de luminosité, des dispositifs de mesure de temps, etc.).

Chaque actionneur peut également être piloté individuellement ou dans un groupe par l'intermédiaire d'un point de commande locale. En particulier, des zones de contrôle sur une même façade peuvent être définies. Sur l'ensemble de chaque zone, les actionneurs seront contrôlés simultanément par l'unité de commande centrale. Une zone peut également correspondre à la totalité d'une façade ou même du bâtiment.

Cependant, il existe un besoin de contrôle plus fin, notamment fenêtre par fenêtre ou équipement par équipement, pour tenir compte de conditions locales, par exemple les ombres portées sur le bâtiment, par une autre partie du bâtiment ou par des éléments environnants, comme d'autres bâtiments ou des reliefs géographiques, ou la circulation du vent et de la pluie en présence du bâtiment et de son environnement. Diverses solutions de gestion des ombres portées ou de modélisation de la circulation des fluides existent. Elles nécessitent généralement une procédure complexe pour la configuration du dispositif de gestion et ne peuvent être ajoutées à des installations existantes. L'invention vise donc à apporter des solutions aux problèmes précités.

En particulier, le procédé de fonctionnement de l'installation selon la présente invention présente une souplesse et une simplicité d'utilisation supérieure aux procédés existants. Par ailleurs, l'installation peut présenter des moyens de calcul de puissance faible pour la gestion des ombres portées, ou plus généralement des conditions locales ce qui en diminue grandement le coût. Par ailleurs, l'invention permet une évolutivité satisfaisante.

On connaît du document US2010/071856A1 un procédé de commande pour contrôler automatiquement la pénétration du soleil dans un bâtiment.

On connaît du document US7977904B2 un système de commande automatique d'un store.

On connaît du document US2006/207730A1 un système de commande automatique d'un store.

On connaît du document EP2357544A2 un procédé gestion de l'énergie utilisant une commande d'un store.

On connaît du document US4457296A une maquette permettant d'étudier le rayonnement solaire sur un bâtiment.

Le but de l'invention est de fournir un procédé de fonctionnement d'une installation remédiant aux inconvénients mentionnés et améliorant les procédés connus de l'art antérieur. En particulier, l'invention propose un procédé de fonctionnement d'une installation permettant une gestion simple et économique des ombres portées, ou plus généralement des conditions locales et des paramètres ambiants, environnants et climatiques sur une zone d'une façade ou un bâtiment.

Un procédé selon l'invention est défini par la revendication 1.

Différents modes d'exécution du procédé sont définis par les revendications 2 à 14.

Une installation selon l'invention est définie par la revendication 15.

L'invention sera mieux comprise à la lecture de la description qui va suivre, donnée uniquement à titre d'exemple et faite en se référant aux dessins annexés sur lesquels :
La figure 1 représente un bâtiment dans lequel un procédé de fonctionnement selon l'invention est mis en œuvre.
La figure 2 représente une installation immotique dans laquelle un procédé de fonctionnement selon l'invention peut être mis en œuvre.
La figure 3 représente un ordinogramme d'un premier mode d'exécution d'un procédé de fonctionnement selon l'invention.
La figure 4 représente des étapes optionnelles du premier mode d'exécution du procédé de fonctionnement.
Les figures 5 et 6 représentent sous forme d'ordinogramme un deuxième, respectivement un troisième mode d'exécution, d'un procédé de fonctionnement selon l'invention.

De manière générale, le procédé de fonctionnement automatique de l'installation tient compte, pour le contrôle des équipements électriques EEi, notamment des équipements électriques équipant les ouvertures du bâtiment, d'une modélisation du bâtiment et de ses ouvertures, ainsi que des conditions locales. Ces conditions locales sont estimées au niveau de différentes zones, c'est-à-dire par exemple au niveau d'une ou plusieurs pièces, au niveau d'une ouverture, au niveau d'un groupe d'ouvertures, ou au niveau d'une partie d'une ouverture.

Les conditions locales, telles que la présence des ombres portées, la température, la circulation du vent ou de la pluie, les risques de gel, etc sont estimées à partir des grandeurs physiques mesurables G associées à ces conditions, en tenant compte de l'influence exercée par le bâtiment et son environnement au niveau de chaque zone Zj.

Ces grandeurs physiques mesurables G sont, par exemple, le flux d'énergie solaire directe reçu par une ouverture ou un groupe d'ouvertures, la vitesse et la direction du vent au niveau d'une façade, les températures extérieure et intérieure au bâtiment, etc.

Les valeurs de ces grandeurs physiques mesurables sont déterminées soit par mesures effectuées par les différents capteurs 13, 23, de l'installation INST, soit à partir des valeurs mesurées Vm des grandeurs physiques et des modèles représentatifs des variations et/ou de corrections de ces grandeurs physiques en présence du bâtiment et de son environnement.

Dans la suite de ce document les grandeurs physiques obtenues auprès des capteurs 13, 23, seront appelés des grandeurs physiques d'entrée F, et celle déterminées à partir des valeurs mesurées et des modèles du bâtiment et de son environnement, grandeurs physiques de sortie G. Au sens de l'invention, le temps chronologique est une grandeur physique d'entrée F ; un dispositif de mesure du temps est un capteur 13, 23.

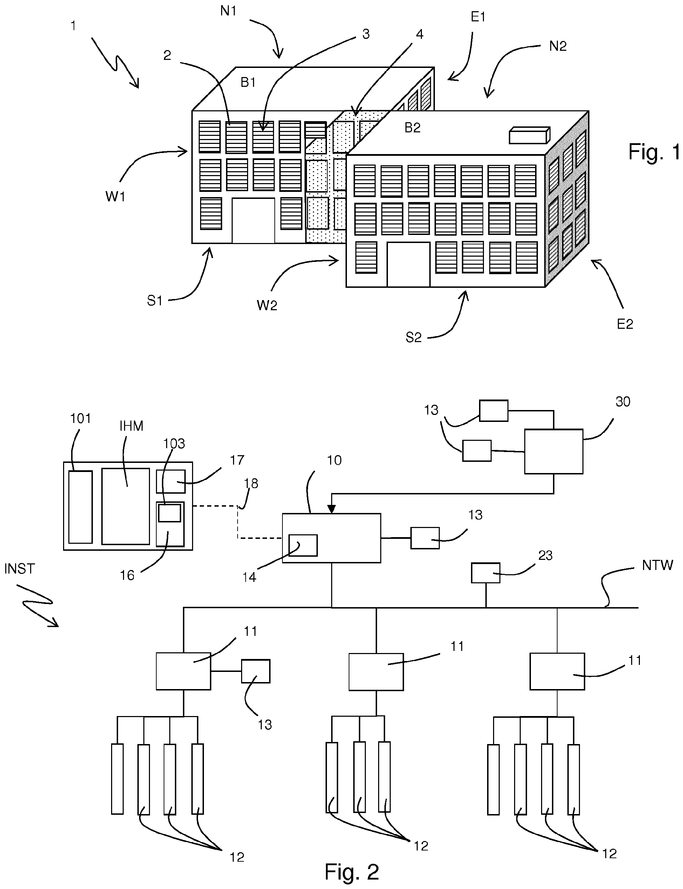

La figure 1 représente un bâtiment 1, par exemple de type tertiaire, en deux parties B1 et B2, à usage de bureaux par exemple. Les deux parties du bâtiment comprennent une pluralité d'ouvertures 2 (notamment des fenêtres) disposées sur des façades S1, S2, E1, E2, N1, N2, W1, W2 (ces quatre dernières façades étant cachées) orientées au Sud, Est, Nord, Ouest. Les ouvertures sont équipées d'écrans mobiles motorisés 3, notamment des écrans de fermeture, d'occultation ou de protection solaire, une partie de ceux-ci étant représentée en position fermée par des hachures horizontales sur les façades S1, S2, E1 et E2.

Afin d'optimiser le confort des utilisateurs et les performances énergétiques de l'installation INST, le pilotage des équipements électriques manœuvrant des écrans tient compte de la présence des ombres portées au niveau de chaque zone Zj du bâtiment.

Une ombre portée sur la façade S1 de la première partie du bâtiment par la deuxième partie du bâtiment est représentée par une zone grisée 4. Le reste des façades visibles est exposé au soleil, recevant ainsi un flux d'énergie solaire directe. Les écrans des ouvertures situées dans la zone d'ombre sont relevés, tandis que les écrans des ouvertures situées au soleil sont baissés de manière à respecter l'exposition propre à chaque ouverture, plutôt que par zone prédéfinie à l'avance au niveau d'une unité de commande centrale.

Une installation automatisée INST, représentée en figure 2, permet la gestion dynamique des façades du bâtiment.

Les écrans de protection solaire mobiles sont chacun pilotés par un actionneur 12, ce dernier permettant l'ouverture et la fermeture automatisée de l'écran. Les actionneurs sont généralement masqués dans des rails ou des caissons lorsqu'ils sont installés et sont alors difficilement accessibles par l'intérieur ou l'extérieur du bâtiment.

L'automatisation de l'installation du bâtiment, notamment des écrans via leurs actionneurs 12, basée sur la présence d'une unité de commande centrale 10, de moyen de commandes locaux 11 et de capteurs divers 13 (présence, luminosité, température, etc), permet de gérer notamment le confort et la thermique dans le bâtiment. Les capteurs 13, 23, peuvent être gérés dans certains modes de réalisation par une unité de gestion des capteurs 30. Pour cela, les différents équipements EEi (actionneurs, moyens de commande, capteurs) communiquent entre eux par le biais de réseaux NTW sans fil (radio notamment) ou filaires (bus câblés, courants porteurs). Un exemple d'installation est représenté en figure 2.

Le terme d'actionneur utilisé dans cette demande comprend notamment la partie électronique ou électromécanique permettant le contrôle du mouvement de l'écran ou le contrôle d'état d'une charge, par exemple d'une lampe, mais également les moyens électroniques de dialogue avec les différents autres équipements de l'installation, notamment les dispositifs d'émission et de réception de trames de communication échangées entre les différents composants de l'installation selon des moyens connus.

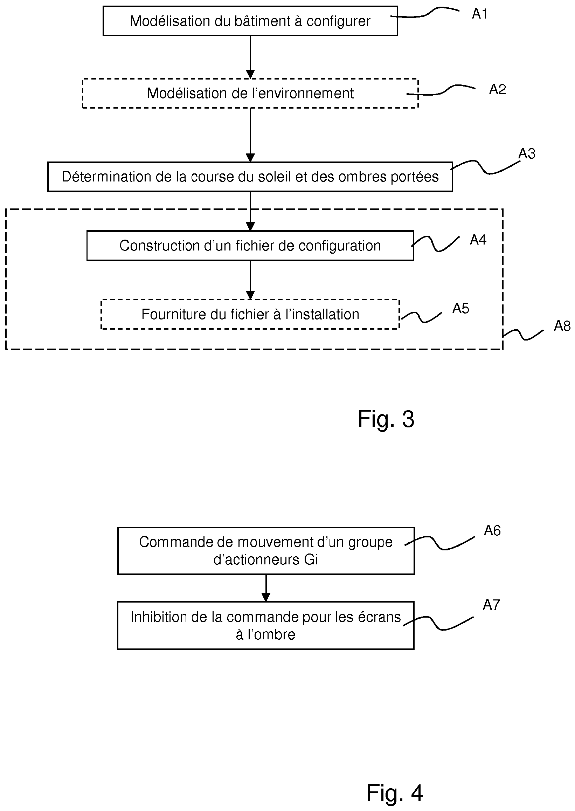

Un premier mode de réalisation simple du procédé de fonctionnement selon l'invention, permet de commander des écrans motorisés en fonction des ombres portées au niveau de chaque zone Zj du bâtiment. Dans ce mode de réalisation, décrit ci-après en référence à la figure 3, une ou plusieurs étapes sont mises en œuvre par un dispositif de configuration 15 comprenant des moyens informatiques, notamment une interface IHM (écran et moyens d'interaction avec celui-ci, par exemple un clavier, une souris et/ou un panneau tactile), des moyens de calcul 16, comme une unité logique de traitement, et des moyens 17 de réception et de transmission d'informations, par exemple par une liaison Internet. Le dispositif de configuration 15 peut être un ordinateur, notamment de type PC, un assistant numérique ou un outil spécifiquement dédié à la configuration d'une telle installation. Il se raccorde à l'installation directement ou par l'intermédiaire d'un des moyens de commande, par voie filaire ou non filaire. Cette connexion 18 est représentée sous la forme d'un trait pointillé, elle peut être temporaire.

Au cours d'une étape A1du procédé de fonctionnement, on met en œuvre une étape de modélisation du bâtiment, notamment une modélisation du bâtiment en trois dimensions et une modélisation des écrans motorisés de protection solaire sur les différentes façades du bâtiment. La modélisation peut comprendre une construction graphique ou une simple identification, par exemple une identification des ouvertures concernées par l'invention. L'utilisation d'un logiciel spécifique dédié à la représentation virtuelle d'une forme en trois dimensions est particulièrement adaptée pour cette étape. En particulier, les dimensions réelles et le positionnement précis des ouvertures destinées à recevoir des écrans motorisés, ainsi que des zones Zj, doivent être respectées au cours de l'étape A1. De préférence, cette modélisation prendra appui sur des plans de construction du bâtiment, voire sur une modélisation fournie par l'architecte en charge de la construction du bâtiment. Des outils de visualisation de l'environnement (de type géoportail ou Google Earth TM) pourront également servir de support à la modélisation du bâtiment concerné. Au cours de cette étape, on saisit ou on récupère donc des données relatives à la géométrie du bâtiment ainsi que des données relatives à l'orientation géographique et à la position géographique du bâtiment.

Au cours d'une étape A2 optionnelle, les structures environnantes sont également modélisées et éventuellement insérées sur la même interface graphique que la modélisation du bâtiment automatisé. Les structures environnantes peuvent être d'autres bâtiments, des reliefs géologiques ou naturels. En particulier dans le cas de reliefs naturels, comme des arbres, une évolution prévisionnelle de la dimension future de ces reliefs peut être intégrée lors de cette étape A2. Au cours de cette étape, on saisit ou on récupère donc des données relatives à la géométrie des structures environnantes ainsi que des données relatives aux positions des structures environnantes relativement au bâtiment.

La modélisation peut être réalisée sous forme d'un maillage de points ou d'objets.

Dans les deux étapes A1 et A2, il est également possible de ne pas modéliser graphiquement le bâtiment, mais de fournir les coordonnées des différents points du maillage pour permettre de déterminer la présence de soleil, c'est-à-dire la présence d'un flux d'énergie solaire directe, ou la présence d'ombres, (flux d'énergie solaire directe inférieur à un seuil prédéterminé) pour chaque point du maillage du bâtiment. Comme déjà mentionné, le temps est une grandeur physique d'entrée au sens de l'invention, qui sera prise en compte dans l'étape A3 de détermination des valeurs, VGj, d'au moins une grandeur physique de sortie Go, dans cet exemple le flux d'énergie solaire directe, au niveau de chaque zone Zj du bâtiment.

Puis au cours d'une troisième étape A3, on détermine, par exemple itérativement les ombres portées sur le bâtiment.

Cette notion de détermination itérative porte sur le fait de réunir par zone Zj et par incréments de temps des données relatives à l'ensemble du bâtiment.

L'ombre portée peut être, comme expliqué précédemment, l'ombre portée par le bâtiment sur lui-même et/ou par les structures environnantes, notamment les structures modélisées au cours de l'étape A2. De manière alternative ou complémentaire, les reflets sur le bâtiment, dus aux structures environnantes peuvent également être modélisés, les reflets étant fonction de la nature ou de la couleur des matériaux constituant les structures environnantes, notamment les façades des structures environnantes.

La détermination itérative est réalisée par une simulation de la course du soleil au cours du temps, par exemple une évaluation des trajectoires des rayons lumineux, et en tenant compte de l'impact des structures se trouvant sur les trajectoires des rayons de soleil simulés. Cette détermination itérative est réalisée pour une localisation géographique du bâtiment donnée (latitude, longitude et orientation des façades), cette information étant fournie par exemple lors de l'étape A1 de modélisation du bâtiment. La détermination itérative peut être réalisée de manière graphique également avec représentation des ombres portées sur le bâtiment au cours du temps.

Préférentiellement, des incréments de temps sont choisis pour cette étape, par exemple une détermination des ombres portées toutes les 15 minutes. La détermination itérative a alors lieu par incréments de temps sur la totalité d'une année calendaire.

L'étape précédente permet de générer un fichier de configuration, comprenant des données représentant la présence ou non d'une ombre portée sur chaque ouverture équipée par un écran motorisé de protection solaire en fonction du temps, au cours d'une étape de calcul A4. Le calcul est mis en œuvre par les moyens de calcul du dispositif de configuration 15, sur la base d'un logiciel spécifiquement mis en œuvre pour cette étape. Avantageusement, ce mode de réalisation, spécifique à une modélisation déportée, permet l'utilisation dans l'installation INST des unités de commande 10, 11, présentant des moyens de calcul limités aux logiques de commande des équipements électriques EEi.

Le logiciel permet en effet de rapporter, à chaque zone Zj représentée, la détermination des valeurs de la grandeur physique de sortie, dans cet exemple le flux d'énergie solaire directe, et donc de la présence ou non d'une ombre portée au cours du temps et d'enregistrer ces données dans le fichier de configuration. Par exemple, le fichier peut comprendre une matrice M comprenant des identifiants des zones Zj en lignes et les différentes dates de l'année en colonnes. Par « date », on entend instant défini par une heure donnée un jour donné de l'année, par exemple 28 janvier 16h15. En choisissant un pas de temps de 15 minutes, on obtient 24×4×365=35040 dates dans une année de 365 jours.

Dans cette matrice, on peut représenter par une valeur donnée, par exemple un « 1 », la présence d'une ombre à une date donnée au niveau d'une ouverture donnée. On peut représenter par une valeur donnée, par exemple un « 0 », l'absence d'une ombre à une date donnée au niveau d'une ouverture donnée. La présence de rayonnement non direct, c'est-à-dire réfléchi au niveau d'une ouverture peut être déterminée par une autre valeur, par exemple « 0.5 ». Cette valeur peut aussi dépendre de l'intensité du rayonnement réfléchi. Dans ce cas, on peut, lors de l'utilisation des données, fixer un seuil et considérer chaque valeur comme égale à « 1 » si elle est supérieure à ce seuil ou comme égale à « 0 » si elle est inférieure ou égale à ce seuil. On peut encore traiter autrement les valeurs.

Enfin, lors d'une cinquième étape A5 le fichier de configuration établi lors de l'étape précédente est fourni à l'unité centrale de commande UC 10 de l'installation associée au bâtiment qui a fait l'objet de la configuration.

Le fichier de configuration comprenant la matrice M contient l'ensemble des valeurs de la grandeur physique de sortie, pour toutes les valeurs que peut prendre la grandeur physique d'entrée, dans cet exemple le temps sur la totalité d'une année calendaire, mesuré avec une résolution de 15 minutes.

Lors de l'utilisation des données, une étape A8 d'obtention de la valeur mesurée Vm du temps courant, permet de déterminer la date courante. Le terme de date recouvre une indication distinguant non seulement un jour mais aussi une heure (relative à un fuseau horaire donné) dans ce jour. Une lecture dans la matrice M de la colonne correspondant à la date courante permet de déterminer, par lecture de la ligne j, la présence ou non d'une ombre portée, pour chaque zone Zj.

Dans ce mode de réalisation l'étape A8 d'obtention de la valeur mesurée Vm de la grandeur physique d'entrée, le temps courant ou la date, est exécutée postérieurement à l'étape de détermination A3 des valeurs VGj, de la grandeur physique de sortie G.

Cette valeur Vm est utilisée pour sélectionner, parmi toutes les valeurs de la grandeur physique de sortie contenues dans la matrice M, celle qui correspond au temps courant et à la zone Zj.

Selon un mode de réalisation préféré, la modélisation lors de l'étape A1 et/ou de l'étape A2 est une modélisation graphique et/ou virtuelle en trois dimensions du bâtiment concerné par la configuration et éventuellement du ou des bâtiments environnants, incluant la localisation des façades et le positionnement des ouvertures équipées d'écrans motorisés de protection solaire sur les façades, ou des reliefs environnants le bâtiment concerné. Cette représentation virtuelle en trois dimensions permet de visualiser la présence des ombres portées ou le flux lumineux direct à un instant donné pour la localisation précise du bâtiment concerné par la configuration, ainsi que de faire varier celle-ci en créant une animation virtuelle par succession d'images à des instants différents.

Alternativement, la représentation graphique pourrait également être en deux dimensions, avec une représentation façade par façade et une reconstruction du bâtiment virtuel uniquement par calcul, sans représentation graphique. Les coordonnées et expositions des façades devraient alors être clairement renseignées pour le bon déroulement du procédé de fonctionnement. La détermination itérative de l'étape A3 serait alors uniquement sous forme de calcul. La représentation virtuelle du bâtiment ne pourrait faire l'objet d'une animation visuelle que sur chaque façade. Les étapes de calcul peuvent être réitérées pour chaque zone de façade ou façade du bâtiment pour lesquelles une information de présence de soleil est fournie.

Le fichier de configuration, ou données de modélisation, peut être renouvelé pour un bâtiment au cours du temps si un changement est intervenu sur le bâtiment (par exemple une modification de la structure ou un changement dans l'installation) ou sur son environnement nécessitant une mise à jour du fichier de configuration. C'est par exemple le cas si un nouveau bâtiment est construit à proximité du bâtiment concerné. C'est encore le cas si la végétation s'est développée à proximité du bâtiment concerné. Cette maintenance est alors plus simple que pour une première configuration si les données de modélisation d'origine ont été conservées. En particulier, l'étape de modélisation du bâtiment peut ne plus être nécessaire, seule l'étape de modélisation de l'environnement, notamment d'un bâtiment environnant, étant alors à mettre en œuvre.

Selon un mode de réalisation de l'invention, les données du fichier de configuration sont des données binaires (1, 0) indiquant ou non la présence d'une ombre portée pour une ouverture donnée à un instant donné. Ces données peuvent alors être fournies sous forme d'un fichier de tableur, par exemple Excel, à l'unité centrale de commande de l'installation.

Une fois le fichier de configuration généré, l'installation est prête à mettre en œuvre un fonctionnement de l'installation tenant compte de la présence d'ombres portées, en particulier avec une gestion ouverture par ouverture. Les données du fichier de configuration peuvent être exploitées directement par l'unité centrale de commande, notamment par transmission vers une entrée spécifique (par exemple une entrée marche/arrêt ou écran activé/écran désactivé prioritaire) en lien avec chaque actionneur ou chaque moyen de commande local pilotant un ou plusieurs actionneurs. Cette réalisation est particulièrement simple lorsque les données du fichier de configuration sont des données binaires. Alternativement, l'unité centrale de commande traduit si nécessaire tout ou partie du fichier de configuration pour le rendre exploitable par une entrée disponible et prioritaire en lien avec chaque actionneur ou chaque moyen de commande local pilotant un ou plusieurs actionneurs.

En fonctionnement, lorsque l'installation reçoit une information de présence de soleil relative à la première zone de façade, elle met en œuvre une étape A6 de commande de mouvement de chaque écran motorisé de protection solaire de la première zone de façade pour positionner les écrans en position fermée. Selon le procédé de l'invention, il est aussi mis en œuvre une étape de commande de mouvement pour positionner des écrans en position ouverte pour les ouvertures se trouvant à l'ombre. Ceci peut être réalisé par une étape inhibition A7 d'inhibition de la commande de mouvement de l'étape A6 pour un ou plusieurs écrans de cette première zone de façade, c'est-à-dire que la commande n'est pas exécutée par les écrans motorisés concernés, si l'information issue du fichier de configuration correspond à la présence d'une ombre portée sur cette ou ces ouvertures associées à cet écran motorisé ou à ces écrans motorisés.

Dans ce cas, les écrans motorisés de la première zone de façade exécutent l'ordre de commande, c'est-à-dire notamment les écrans sont baissées pour permettre une régulation des entrées lumineuses à l'intérieur du bâtiment, à part celui ou ceux pour lesquels une ombre portée est déterminée. Il est possible de prévoir que, dans un fonctionnement inverse, par exemple en hiver et en l'absence de personnes dans le bâtiment, l'ordre de commande sur détection de présence de soleil est un ordre de remontée des stores, pour bénéficier au contraire des apports calorifiques. Le ou les écrans concernés par la présence d'une ombre portée peuvent ainsi rester dans leur configuration initiale, par exemple ils peuvent être maintenus baissés. La commande de mouvement est alors également inhibée.

Selon un mode de réalisation de l'invention, les données du fichier de configuration sont fournies directement, notamment lorsqu'il s'agit de données binaires ou indirectement (les données étant alors interprétées), sélectivement au cours du temps au niveau d'une entrée d'un actionneur, d'un groupe d'actionneur ou d'un moyen de commande local d'un ou plusieurs actionneurs de manœuvre d'écran motorisé. L'actionneur lui-même, ou le moyen de commande local inhibe au cas par cas les ordres reçus par l'unité centrale de commande.

Selon un mode de réalisation alternatif, l'unité centrale de commande traite les informations issues du fichier de configuration et émet sélectivement des ordres de commande uniquement à l'attention des écrans faisant l'objet d'un ensoleillement. Dans les deux cas, la commande de mouvement associée à l'information de présence de soleil sur la première zone de façade est dite inhibée pour les écrans concernés par la présence d'ombres portées.

Une nouvelle commande de mouvement est transmise vers les écrans motorisés en cas de besoin, c'est-à-dire notamment soit parce que le soleil n'est plus présent (l'information de présence de soleil disparaît) ou parce que les données du fichier indiquent une modification, du fait du temps écoulé, sur les présences d'ombres portées sur les différentes ouvertures de la première zone de façade. L'unité centrale 11 de commande vérifie donc régulièrement la cohérence entre les informations de présence de soleil et de présence d'ombres portées.

Préférentiellement, le fichier de configuration est préalablement établi en tenant compte de la fréquence de vérification opérée par l'unité centrale de commande.

Le contrôle des écrans motorisés de l'installation tenant compte de la présence d'ombres portées est donc indépendant d'un contrôle évolué de la position et de l'angle du soleil en temps réel. Un capteur d'ensoleillement fournissant une information de présence ou d'absence de soleil, ou plus généralement une information de niveau d'ensoleillement, peut être suffisant pour permettre le contrôle précis selon l'invention.

De manière plus fine, il est envisageable que le fichier de configuration fournisse des informations liées à des parties d'ouvertures. Ainsi des positions intermédiaires dans lesquelles positionner les écrans lorsque seule une partie de l'ouverture est couverte par une ombre portée par le bâtiment ou son environnement pourraient être déterminées. L'inhibition de commande concernerait alors une inhibition partielle, un mouvement étant autorisé sur une partie de la course d'un écran et bloqué sur une autre partie.

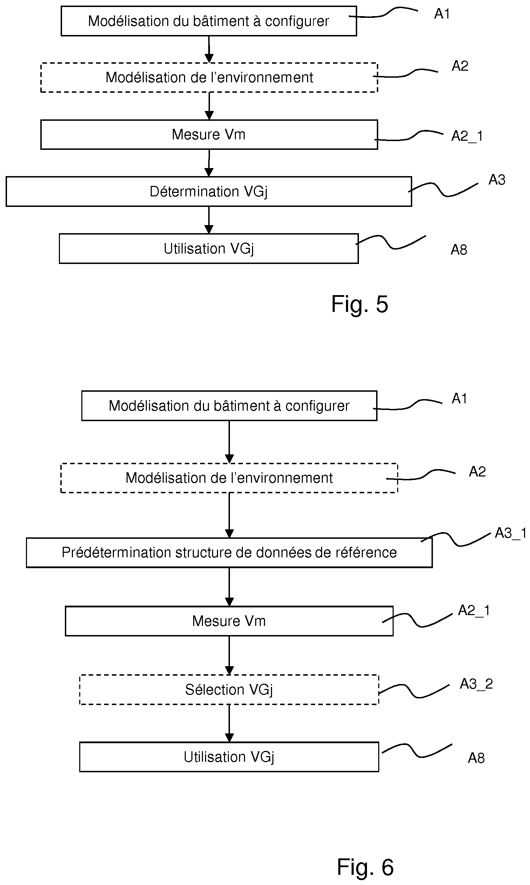

Un deuxième mode de réalisation du procédé de fonctionnement, est décrit ci-après en référence à la figure 5. Les étapes A1 et éventuellement A2, de modélisation du bâtiment et de son environnement, sont similaires aux étapes A1 et A2 du premier mode de réalisation.

Pour optimiser le confort et les performances énergétiques du bâtiment, l'installation INST utilise, dans ce mode de réalisation, des valeurs évaluées d'une grandeur physique, par exemple le flux lumineux au niveau de chaque zone Zj.

La grandeur physique de sortie est donc un flux lumineux. Pour le déterminer, deux grandeurs physiques d'entrée sont prises en compte : le temps courant, et le flux lumineux solaire mesuré par un capteur 13 de l'installation. Ce capteur 13 peut être un pyranomètre ou un albédomètre, des dispositifs aptes à mesurer le flux lumineux solaire global, direct ou réfléchi. La localisation du capteur 13 est intégrée dans le modèle du bâtiment.

Lors de l'étape A2_1 deux valeurs, Vm, Vm1, sont mesurées pour les deux grandeurs physiques d'entrée précitées : le temps, respectivement le flux lumineux reçu au niveau du capteur 13.

Ensuite, lors de l'étape A3, les valeurs VGj du flux lumineux reçu au niveau de chaque zone Zj sont déterminées par calculs, utilisant les données obtenues lors des étapes précédentes.

Le modèle du bâtiment obtenu lors de l'étape A1 comprend des données relatives à la géométrie, à l'orientation et à la position géographique du bâtiment. Il peut comprendre également des données relatives à la géométrie et à la position des structures environnantes, obtenues lors de l'étape optionnelle A2.

En fonction de la localisation géographique du bâtiment et de la valeur Vm du temps courant (jour dans l'année et moment ou heure dans la journée) mesurée lors de l'étape A2_1, on peut calculer la position soleil. Ensuite, on évalue les trajectoires des rayons lumineux. Enfin, connaissant la localisation du capteur 13 sur le bâtiment et les trajectoires des rayons lumineux, on peut déterminer l'angle d'incidence sous lequel le flux lumineux solaire mesuré est reçu au niveau du capteur 13.

Ensuite, les données concernant l'orientation et la position de chaque zone Zj permettent de déterminer l'angle d'incidence sous lequel le flux lumineux solaire est reçu au niveau de la zone Zj, en tenant compte de l'impact des structures se trouvant sur les trajectoires des rayons de soleil simulés. En combinant ces informations avec la valeur mesurée Vm1 du flux lumineux reçu par le capteur 13, on peut calculer la valeur VGj du flux lumineux au niveau de chaque zone Zj.

Ces valeurs VGj constituent des évaluations des valeurs de la grandeur physique Go au niveau des zones Zj et peuvent remplacer avantageusement des éventuelles valeurs issues des mesures effectuées par des capteurs réels qui seraient placés au niveau de chaque zone Zj ; ces valeurs déterminées VGj sont considérées être des valeurs issues de « capteurs virtuels ». Elles sont utilisées dans une étape A8 comme le seraient des valeurs issues de capteurs réels.

Les valeurs VGj ainsi déterminées sont fournies ensuite à l'unité centrale de commande 10 et/ou aux unités de commande locales 11 et sont traitées comme des valeurs mesurées de la grandeur physique G. Ces valeurs sont envoyées progressivement, en simulant des acquisitions effectuées au fil du temps par les « capteurs virtuels », au niveau des zones Zj. De cette manière l'installation peut fournir un fonctionnement déterminé zone par zone, en tenant compte des conditions locales, sans le surcout des capteurs réels supplémentaires. Chaque zone Zj reçoit ainsi une valeur qui lui est propre au lieu d'une valeur centralisée.

L'étape de détermination itérative A3 peut être exécutée par une des unités de commande 10, 11, ou par l'unité de gestion de capteurs 30. Dans ce dernier cas le calcul correspondant à la détermination des valeurs VGj est à la charge de l'unité de gestion des capteurs 30, permettant, comme dans le mode de réalisation précédemment décrit, l'utilisation dans l'installation INST des unités de commande 10, 11, présentant des moyens de calcul de puissance faible.

Il est important de noter que dans ce deuxième mode de réalisation l'étape A2_1 d'obtention des valeurs mesurées Vm, Vm1, des grandeurs physiques d'entrée, est exécutée préalablement à l'étape A3 de détermination itérative des valeurs VGo1j de la grandeur physique de sortie G.

De manière avantageuse, le procédé selon l'invention permet une mise à jour d'une installation INST par simple ajout ou mise à jour d'un seul dispositif, notamment, dans ce mode de réalisation, l'unité de gestion des capteurs 30. En effet, les dispositifs en place, les unités de commande 10, 11, et les équipements électriques EEi sont aptes à communiquer via le réseau NTW, obtenir ainsi des informations issues des capteurs 13 et les utiliser pour déterminer leur fonctionnement.

Dans les solutions connues, les informations relatives aux grandeurs physiques étant fournies seulement par le ou les capteurs 13, un contrôle fin, zone par zone, peut être obtenu par ajout de capteurs réels 13 dans l'installation. Cette solution entraîne un surcout significatif, une intervention sur le site pour installer, zone par zone, des nouveaux capteurs 13, et l'appairage ou l'établissement des liens de communication entre les capteurs ajoutés et les équipements existants dans l'installation INST. Par l'application du procédé proposé par l'invention le contrôle fin des équipements électriques EEi, zone par zone, est obtenu à faible coût et nécessitant seulement une intervention simple sur site.

Un autre mode de réalisation est représenté à la figure 6. Ce mode de réalisation diffère du mode de réalisation précédent en ce que l'étape A3 comprend en outre une sous-étape A3_1 de prédétermination d'une structure de données de référence DR et une sous-étape A3_2 de sélection des valeurs VGj des grandeurs physiques de sortie dans cette structure de données de référence DR.

Cette structure de données de référence est constituée d'un ensemble prédéterminé d'associations, comprenant des valeurs des grandeurs physiques d'entrée associées à des valeurs de la ou des grandeurs physiques de sortie. La structure et le mode d'obtention des associations sont expliqués ci-après.

On suppose que l'installation prend en compte m grandeurs physiques d'entrée pour déterminer les valeurs de n grandeurs physiques de sortie. Une association appartenant à la structure de données de référence DR est constituée de :
- m éléments, représentant chacun une valeur d'une des m grandeurs physiques d'entrée ; et de
- n éléments, représentant chacun une valeur d'une des n grandeurs physiques de sortie.

Les n valeurs des grandeurs physiques de sortie d'une association sont calculées pour chaque zone Zj en fonction
- des m grandeurs physiques d'entrée, et dans l'hypothèse que les valeurs des m grandeurs physiques d'entrée sont égales aux m éléments les représentant dans l'association considérée, et
- du modèle du bâtiment, éventuellement du modèle de son environnement, de la localisation de la zone Zj dans le bâtiment et en prenant en compte l'influence du bâtiment et de son environnement sur le comportement des grandeurs physiques de sortie.

Lors de la constitution de la structure de données de référence DR on sélectionne pour chaque grandeur physique d'entrée F les valeurs à prendre en compte pour la détermination des grandeurs physiques de sortie.

Si la grandeur physique d'entrée est une grandeur pouvant prendre des valeurs continues (par exemple la température, le flux lumineux, etc.), le domaine des valeurs possibles de la grandeur physique d'entrée est divisé en plages de valeurs, et pour chaque plage k de valeurs (Vk_min,Vk_Max), une valeur Vrk, telle que Vk_min <= Vrk <= Vk_Max, étant choisie en tant que valeur représentative de la plage k. On considère que la valeur Vrk, représentative de la plage k, est représentative pour toute valeur mesurée Vm, Vm1 de la grandeur physique d'entrée appartenant à la plage k.

Si la grandeur physique F est une grandeur pouvant prendre des valeurs discrètes (par exemple présence/absence d'un utilisateur), les valeurs à prendre en compte sont choisies parmi les valeurs discrètes possibles. Toutes les valeurs discrètes ne sont pas nécessairement choisies ; certaines valeurs choisies peuvent être considérées représentatives pour plusieurs valeurs discrètes de la même grandeur physique d'entrée.

Une fois les valeurs représentatives à prendre en compte pour chacune des m grandeurs physiques d'entrée sélectionnées, on calcule les valeurs des n grandeurs physiques de sortie pour les différentes combinaisons de m valeurs représentatives des grandeurs physiques d'entrée.

La structure de données de référence est de préférence constituée lors de la sous-étape A3_1 de prédétermination par un dispositif de configuration 15, permettant ainsi une modélisation déportée. Il est important de noter que la constitution de cette structure de données de référence DR peut être effectuée préalablement au fonctionnement de l'installation. Elle peut être aussi mise à jour si des changements sont intervenus sur les modèles du bâtiment ou de son environnement.

En fonctionnement de l'installation, lors de l'étape A8, m valeurs mesurées sont obtenues, une pour chacune des m grandeurs physiques d'entrée. Ensuite sont déterminées les m valeurs représentatives de ces valeurs mesurées, dites valeurs d'entrée.

Dans ce mode de réalisation les valeurs des n grandeurs physiques de sortie sont obtenues lors de la sous-étape A3_2 de sélection dans la structure de données de référence DR. D'abord on sélectionne dans la structure de données DR l'association comprenant les m valeurs d'entrée. Les n valeurs des grandeurs physiques de sortie sont les n éléments associés aux m valeurs d'entrée dans l'association sélectionnée.

Il est important de noter que la structure de données de référence contient des associations pour chaque zone Zj du bâtiment, permettant ainsi une détermination itérative, zone par zone, des valeurs des grandeurs physiques de sortie.

Les calculs tiennent compte du modèle du bâtiment et de son environnement, ainsi que des simulations numériques des comportements des n grandeurs physiques de sortie, en présence du bâtiment et en fonction de la grandeur physique d'entrée.

Les étapes A3_1 et A3_2 peuvent être exécutées par deux dispositifs différents, par exemple le dispositif de configuration 15, respectivement l'unité de commande 10, 11. Avantageusement, ce mode de réalisation permet d'effectuer l'étape A3_1 de prédétermination de manière déportée.

Dans certains modes de réalisation, l'installation INST peut comprendre en outre au moins un deuxième capteur 23 apte à mesurer la grandeur physique de sortie G au niveau d'une zone Zk du bâtiment 1, le modèle du bâtiment intégrant la localisation du /des deuxièmes capteurs 23 par rapport aux zones du bâtiment.

L'étape A3 de détermination itérative, illustrée par la figure 6, peut combiner une des méthodes précédemment décrites avec des étapes de mesure des valeurs des grandeurs physiques de sortie. Ces étapes de mesure sont effectuées au niveau d'une zone Zk si un/des deuxièmes capteurs 23 sont localisés au niveau de cette zone Zk ; dans le cas contraire, une quelconque des méthodes précédentes peut être utilisée pour I la détermination des valeurs VGj.

Dans un autre mode de réalisation une maquette du bâtiment, à échelle réduite et équipée de capteurs 13, est réalisée et installée dans des conditions de position géographique et d'orientation similaires aux conditions du bâtiment. La maquette comporte des zones zi placées dans des conditions similaires à des zones Zj du bâtiment. Chaque zone zi est équipée de capteurs réels 13 aptes à mesurer l'au moins une grandeur physique d'entrée F. Lors de l'étape A3 de détermination des valeurs des grandeurs physiques de sortie, une étape de calcul est effectué, en tenant compte de similitudes de conditions d'exposition des zones de la maquette zi et Zj du bâtiment, ainsi que du modèle de structures environnantes obtenu lors de l'étape A2.

Par exemple, si une zone zi a la même exposition que une ou plusieurs zones Zj du bâtiment, la valeur Vm du flux d'énergie solaire directe mesurée par un capteur 13 placé au niveau de la maquette est considéré représentative d'une valeur VGj du flux d'énergie solaire directe reçue au niveau de la ou des zones Zj du bâtiment ayant la même exposition. Cette méthode de détermination peut être combinée avec la modélisation des structures environnantes du bâtiment. Ainsi, la valeur Vm du flux d'énergie solaire directe mesurée par un capteur 13 placé au niveau de la maquette est considérée représentative de la valeur VGj du flux d'énergie reçue seulement en absence d'obstacles entre la zone Zj et le soleil. De manière avantageuse cette méthode permet d'avoir des mesures effectuées en temps réel par les capteurs 13 installés au niveau de la maquette, sans avoir à modifier l'installation INST pour installer des capteurs.

L'invention concerne également un support de données, étant apte à stocker notamment un fichier de configuration ou une structure de données de référence. Le fichier de configuration peut contenir des données et être issu d'une modélisation du bâtiment 1 et des ouvertures sur des façades N1, N2, S1, S2, W1, W2, E1, E2 du bâtiment, d'une détermination itérative de l'ombre portée par le bâtiment sur lui-même et/ou par les structures environnantes également modélisées en fonction du temps et pour une localisation géographique du bâtiment donnée, les données représentant la présence ou non d'une ombre portée sur chaque ouverture ou chaque partie d'une ouverture équipée par un écran motorisé de protection solaire en fonction du temps. Le fichier peut alternativement contenir des données déterminées par l'étape A3 de détermination itérative de valeurs VGj d'au moins une grandeur physique de sortie G, en fonction d'au moins une deuxième valeur Vf de la grandeur physique d'entrée et du modèle du bâtiment 1.

Une installation INST de commande automatisée des conditions de confort et/ou de sécurité dans le bâtiment comprend l'unité centrale de commande 10, les équipements électriques EEi équipant les zones Zj du bâtiment et l'unité de gestion des capteurs 30 comprenant l'au moins un capteur 13 apte à mesurer la grandeur physique d'entrée F. L'installation comprend des éléments 10 ; 11 ; 13 ; 15 ; 30 matériels et/ou logiciels de mise en œuvre du procédé régissant son fonctionnement.

Les éléments matériels et/ou logiciels peuvent comprendre :
- un élément 101 de saisie de données de modélisation du bâtiment 1 et des zones Zj du bâtiment ou de stockage de données de stockage de modélisation du bâtiment 1 et des zones Zj du bâtiment,
- un élément 103 de détermination itérative de valeurs VGj de l'au moins une grandeur physique de sortie G, en fonction de l'au moins une deuxième valeur Vf de la grandeur physique d'entrée et du modèle du bâtiment 1,
- une élément 10 ; 11 utilisant les valeurs déterminées VGj afin de commander les équipements électriques EEi équipant chaque zone (Zj) du bâtiment.

Dans les revendications qui suivent, le terme « temps » a un sens chronologique et non un sens météorologique.

## Revendications

1. Procédé de fonctionnement d'une installation (INST) pour le contrôle automatisé des conditions de confort dans un bâtiment (1), l'installation (INST) comprenant une unité centrale de commande (10), des équipements électriques (EEi) équipant des zones (Zj) du bâtiment, et une unité de gestion de capteurs (30) comprenant au moins un capteur (13) apte à mesurer une grandeur physique d'entrée (F), le procédé étant **caractérisé en ce qu'**il comprend les étapes suivantes mises en œuvre par l'installation :
- Une étape (A1) de modélisation du bâtiment (1), des zones (Zj) du bâtiment et d'ouvertures du bâtiment,
- Une étape (A2_1) d'obtention d'au moins une première valeur (Vm) de la grandeur physique d'entrée (F) mesurée par l'au moins un capteur (13), dite valeur mesurée, la grandeur physique d'entrée (F) étant un temps chronologique,
- Une étape (A3) de détermination de valeurs (VGj) de grandeurs physiques de sortie (G), en fonction de la première valeur (Vm) de la grandeur physique d'entrée (F), du modèle du bâtiment (1), des zones (Zj) du bâtiment et des ouvertures du bâtiment,
l'étape (A3) de détermination comprenant :
une sous-étape (A3_1) de prédétermination d'une structure de données de référence (DR) comprenant des valeurs (VGj) des grandeurs physiques de sortie calculées pour une pluralité de valeurs de la grandeur physique d'entrée, la sous-étape (A3_1) de prédétermination comprenant la détermination itérative des valeurs (VGj) des grandeurs physiques de sortie (G) réalisée par une simulation de la course du soleil au cours du temps et en tenant compte de l'impact des structures se trouvant sur les trajectoires des rayons solaires simulés, ladite détermination itérative de valeurs (VGj) étant réalisée pour une localisation géographique donnée du bâtiment, les grandeurs physiques de sortie (G) étant des flux d'énergie solaire directs au niveau de chaque zone (Zj) du bâtiment, et
une sous-étape (A3_2) de sélection des valeurs des grandeurs physiques de sortie dans cette structure de données de référence, en fonction de l'au moins une première valeur (Vm), et
- Une étape (A8) d'utilisation des valeurs déterminées (VGj) afin de commander les équipements électriques (EEi) équipant chaque zone (Zj) du bâtiment, l'équipement électrique équipant une zone étant commandé par les valeurs déterminées pour cette zone, l'étape d'utilisation comprenant une fourniture de valeurs à l'unité centrale de commande et/ou à des unités de commande locales en charge de générer et/ou envoyer des commandes aux équipements électriques équipant chaque zone du bâtiment.

2. Procédé de fonctionnement selon la revendication 1, **caractérisé en ce que** l'étape (A3) de détermination itérative comprend une étape de détermination, notamment par calcul, des valeurs (VGj) de l'au moins une grandeur physique de sortie (G), pour au moins deux zones (Zj) du bâtiment.

3. Procédé de fonctionnement selon l'une des revendications précédentes, **caractérisé en ce que** la structure de données de référence (DR) comprend, pour chaque zone (Zj), un ensemble prédéterminé d'associations ({Vrk, VGj} entre
- des valeurs prédéfinies représentatives (Vrk) de plages de valeurs de la grandeur physique d'entrée (F); et
- des valeurs prédéfinies représentatives (VGj) de plages de valeurs de la grandeur physique de sortie (G);
la sous-étape (A3_2) de sélection comprenant
- une sous-étape de détermination d'une valeur représentative (Vrm) de la première valeur (Vm), dite valeur d'entrée;
- une sous-étape de détermination d'une valeur prédéfinie (VGm) de la grandeur physique de sortie (G), dite valeur de sortie, telle que l'association {Vrm, VGm} entre valeur d'entrée et valeur de sortie appartient à l'ensemble prédéterminé d'associations de la structure de données de référence (DR).

4. Procédé de fonctionnement selon l'une des revendications précédentes, **caractérisé en ce que**
- la sous-étape étape (A3_1) de prédétermination de la structure de données de référence (DR) est exécutée par un dispositif de configuration (15) ; et
- la sous-étape étape (A3_2) de sélection de valeurs (VGj) des grandeurs physiques de sortie est exécutée par l'unité centrale de commande (10) et/ou par les unités locales de commande (11).

5. Procédé de fonctionnement selon l'une des revendications précédentes, **caractérisé en ce que**
- l'installation (INST) comprend en outre au moins un troisième capteur apte à mesurer l'au moins une grandeur physique de sortie (G) au niveau d'une zone (zj) d'une maquette du bâtiment (1), la zone (zj) de la maquette étant une image d'une zone (Zj) du bâtiment ;
- le modèle du bâtiment comprend une association de la localisation de l'au moins un troisième capteur à une localisation au niveau d'une zone du bâtiment (Zj) ;
- l'étape (A3) de détermination itérative comprend une étape de mesure des valeurs (VGk) de l'au moins une grandeur physique de sortie (G) au niveau d'une zone (zj) si l'au moins un troisième capteur est localisé au niveau de cette zone.

6. Procédé de fonctionnement selon l'une des revendications précédentes, **caractérisé en ce que**
- l'installation (INST) comprend en outre au moins un deuxième capteur (23) apte à mesurer l'au moins une grandeur physique de sortie (G) au niveau d'une zone (Zj) du bâtiment (1) ;
- le modèle du bâtiment comprend la localisation de l'au moins un deuxième capteur (23) par rapport aux zones du bâtiment (Zj) ;
- l'étape (A3) de détermination itérative comprend une étape de mesure des valeurs (VGk) de l'au moins une grandeur physique de sortie (G) au niveau d'une zone (Zj) si l'au moins un deuxième capteur (23) est localisé au niveau de cette zone.

7. Procédé de fonctionnement selon l'une des revendications 1 à 6, **caractérisé en ce que** l'étape d'utilisation (A8) consiste à fournir les valeurs déterminées (VGj) à l'unité centrale de commande (10) et/ou à des unités de commande locales (11) en charge de générer et/ou envoyer des commandes à des équipements électriques (EEi) équipant chaque zone (Zj) du bâtiment, notamment sous forme de flux de données.

8. Procédé de fonctionnement selon l'une des revendications 1 à 6, **caractérisé en ce que** l'étape d'utilisation (A8) comprend une étape de sélection de valeurs de paramètres (Pj) pour la commande des équipements électriques (EEi), dans une deuxième structure de données de référence (DR2) comprenant, pour chaque zone (Zj), un ensemble prédéterminé d'associations ({VGj, Pj}) entre
- des valeurs prédéfinies de la grandeur physique de sortie (VGj) ; et
- des valeurs prédéfinies des paramètres (Pj),
les valeurs sélectionnées des paramètres étant les valeurs prédéfinies associées dans la deuxième structure de données de référence (DR2) aux valeurs déterminées (VGj).

9. Procédé de fonctionnement selon l'une des revendications précédentes, **caractérisé en ce que** l'étape (A8) d'utilisation comprend :
- Une étape (A6) de commande de mouvement de chaque écran motorisé de protection solaire d'une première zone (Zj) de façade en fonction d'une information de présence de soleil relative à la première zone (Zj) de façade,
- Une étape (A7) d'inhibition de la commande de mouvement de l'étape précédente en fonction des données du fichier de configuration relatives à chaque ouverture de la zone.

10. Procédé de fonctionnement selon la revendication 9, **caractérisé en ce que** l'étape d'inhibition dépend d'une information de niveau d'ensoleillement.

11. 11 Procédé de fonctionnement selon l'une des revendications précédentes, **caractérisé**
- **en ce qu'**il comprend en outre une étape (A2) de modélisation virtuelle des structures environnantes du bâtiment, et
- **en ce que** l'étape (A3) de détermination itérative est effectuée aussi en fonction du résultat de cette modélisation virtuelle des structures environnantes du bâtiment.

12. Procédé de fonctionnement selon l'une des revendications précédentes, **caractérisé en ce que** la modélisation de l'étape (A1) est une modélisation virtuelle en trois dimensions du bâtiment, incluant la localisation des façades (N1, N2, S1, S2, W1, W2, E1, E2) et le positionnement des ouvertures équipées d'écrans motorisés de protection solaire sur les façades.

13. Procédé de fonctionnement selon l'une des revendications précédentes, **caractérisé en ce qu'**une étape de détermination itérative des ombres portées par le bâtiment sur lui-même et/ou par les structures environnantes également modélisées en fonction du temps et pour une localisation géographique du bâtiment donnée peut être réalisée par façade et réitérée pour chaque façade du bâtiment pour lesquelles une information de présence de soleil ou de flux d'énergie directe ou de flux lumineux direct est fournie.

14. Installation (INST) de commande automatisée des conditions de confort dans un bâtiment (1), l'installation (INST) comprenant une unité centrale de commande (10), des équipements électriques (EEi) équipant des zones (Zj) du bâtiment et une unité de gestion de capteurs (30) comprenant au moins un capteur (13) apte à mesurer une grandeur physique d'entrée (F), **caractérisée en ce qu'**elle comprend des éléments (10 ; 11 ; 13 ; 15 ; 30) matériels et/ou logiciels de mise en œuvre du procédé selon l'une des revendications précédentes, les éléments matériels et/ou logiciels comprenant :
- un élément (101) de saisie de données de modélisation du bâtiment (1) et des zones (Zj) du bâtiment ou un élément (101) de stockage de données de stockage de modélisation du bâtiment (1) et des zones (Zj) du bâtiment,
- un élément (103) de détermination itérative de valeurs (VGj) d'au moins une grandeur physique de sortie (G), en fonction d'au moins une valeur (Vf) de la grandeur physique d'entrée et du modèle du bâtiment (1),
- un élément (10 ; 11) utilisant des valeurs déterminées (VGj) afin de commander les équipements électriques (EEi) équipant chaque zone (Zj) du bâtiment,
l'installation étant configurée pour mettre en œuvre les étapes suivantes :
- Une étape (A1) de modélisation du bâtiment (1), des zones (Zj) du bâtiment et d'ouvertures du bâtiment,
- Une étape (A2_1) d'obtention d'au moins une première valeur (Vm) de la grandeur physique d'entrée (F) mesurée par l'au moins un capteur (13), dite valeur mesurée, la grandeur physique d'entrée (F) étant un temps chronologique,
- Une étape (A3) de détermination de valeurs (VGj) de grandeurs physiques de sortie (G), en fonction de la première valeur (Vm) de la grandeur physique d'entrée (F), du modèle du bâtiment (1), des zones (Zj) du bâtiment et des ouvertures du bâtiment,
l'étape (A3) de détermination comprenant :
une sous-étape (A3_1) de prédétermination d'une structure de données de référence (DR) comprenant des valeurs (VGj) des grandeurs physiques de sortie calculées pour une pluralité de valeurs de la grandeur physique d'entrée, la sous-étape (A3_1) de prédétermination comprenant la détermination itérative des valeurs (VGj) des grandeurs physiques de sortie (G) réalisée par une simulation de la course du soleil au cours du temps et en tenant compte de l'impact des structures se trouvant sur les trajectoires des rayons solaires simulés, ladite détermination itérative de valeurs (VGj) étant réalisée pour une localisation géographique donnée du bâtiment, les grandeurs physiques de sortie (G) étant des flux d'énergie solaire directs au niveau de chaque zone (Zj) du bâtiment, et
une sous-étape (A3_2) de sélection des valeurs des grandeurs physiques de sortie dans cette structure de données de référence,
en fonction de l'au moins une première valeur (Vm), et
- Une étape (A8) d'utilisation des valeurs déterminées (VGj) afin de commander les équipements électriques (EEi) équipant chaque zone (Zj) du bâtiment, l'équipement électrique équipant une zone étant commandé par les valeurs déterminées pour cette zone, l'étape d'utilisation comprenant une fourniture de valeurs à l'unité centrale de commande et/ou à des unités de commande locales en charge de générer et/ou envoyer des commandes aux équipements électriques équipant chaque zone du bâtiment.

## Patentansprüche

1. Verfahren zum Betreiben einer Anlage (INST) zur automatisierten Regelung der Komfortbedingungen in einem Gebäude (1), die Anlage (INST) umfassend eine zentrale Steuerungseinheit (10), elektrische Ausrüstungen (EEi), mit denen Zonen (Zj) des Gebäudes ausgestattet sind, und eine Sensorenverwaltungseinheit (30), die mindestens einen Sensor (13) umfasst, der geeignet ist, eine physikalische Eingangsgröße (F) zu messen, wobei das Verfahren **dadurch gekennzeichnet ist, dass** es die folgenden von der Anlage ausgeführten Schritte umfasst:
- einen Schritt (A1) des Modellierens des Gebäudes (1), der Zonen (Zj) des Gebäudes und von Öffnungen des Gebäudes,
- einen Schritt (A2_1) des Erhaltens mindestens eines ersten Werts (Vm) der physikalischen Eingangsgröße (F), der von dem mindestens einen Sensor (13) gemessen wird, Messwert genannt, wobei die physikalische Eingangsgröße (F) eine Uhrzeit ist,
- einen Schritt (A3) des Bestimmens von Werten (VGj) von physikalischen Ausgangsgrößen (G) in Abhängigkeit von dem ersten Wert (Vm) der physikalischen Eingangsgröße (F), von dem Modell des Gebäudes (1), von den Zonen (Zj) des Gebäudes und von den Öffnungen des Gebäudes,
wobei der Schritt (A3) des Bestimmens umfasst:
einen Teilschritt (A3_1) des Vorbestimmens einer Referenzdatenstruktur (DR), die Werte (VGj) der physikalischen Ausgangsgrößen umfasst, die für eine Vielzahl von Werten der physikalischen Eingangsgröße berechnet werden, wobei der Teilschritt (A3_1) des Vorbestimmens das iterative Bestimmen der Werte (VGj) der physikalischen Ausgangsgrößen (G) umfasst, das durch eine Simulation des Laufs der Sonne im Laufe der Zeit und unter Berücksichtigung des Einflusses der Strukturen, die sich auf den Bahnen der simulierten Sonnenstrahlen befinden, ausgeführt wird, wobei das iterative Bestimmen von Werten (VGj) für eine gegebene geographische Lage des Gebäudes ausgeführt wird, wobei die physikalischen Ausgangsgrößen (G) direkte Sonnenenergieflüsse an jeder Zone (Zj) des Gebäudes sind, und
einen Teilschritt (A3_2) des Auswählens der Werte der physikalischen Ausgangsgrößen in dieser Referenzdatenstruktur in Abhängigkeit von dem mindestens einen ersten Wert (Vm), und
- einen Schritt (A8) des Verwendens der bestimmten Werte (VGj), um die elektrischen Ausrüstungen (EEi) zu steuern, mit denen jede Zone (Zj) des Gebäudes ausgestattet ist, wobei die elektrische Ausrüstung, mit der eine Zone ausgestattet ist, durch die für diese Zone bestimmten Werte gesteuert wird, wobei der Schritt des Verwendens eine Bereitstellung von Werten für die zentrale Steuerungseinheit und/oder für lokale Steuerungseinheiten umfasst, die dafür zuständig sind, Befehle an die elektrischen Ausrüstungen, mit denen jede Zone des Gebäudes ausgestattet ist, zu erzeugen und/oder zu senden.

2. Verfahren zum Betreiben nach Anspruch 1, **dadurch gekennzeichnet, dass** der Schritt (A3) des iterativen Bestimmens einen Schritt des Bestimmens, insbesondere durch Berechnung, der Werte (VGj) der mindestens einen physikalischen Ausgangsgröße(G) für mindestens zwei Zonen (Zj) des Gebäudes umfasst.

3. Verfahren zum Betreiben nach einem der vorhergehenden Ansprüche, **dadurch gekennzeichnet, dass** die Referenzdatenstruktur (DR) für jede Zone (Zj) einen vorbestimmten Satz von Zuordnungen ({Vrk, VGj} umfasst zwischen
- repräsentativen vorgegebenen Werten (Vrk) für Wertebereiche der physikalischen Eingangsgröße (F); und
- repräsentativen vorgegebenen Werten (VGj) für Wertebereiche der physikalischen Ausgangsgröße (G);
wobei der Teilschritt (A3_2) des Auswählens umfasst
- einen Teilschritt des Bestimmens eines repräsentativen Werts (Vrm) für den ersten Wert (Vm), Eingangswert genannt;
- einen Teilschritt des Bestimmens eines vorgegebenen Werts (VGm) der physikalischen Ausgangsgröße (G), Ausgangswert genannt, derart, dass die Zuordnung {Vrm, VGm} zwischen Eingangswert und Ausgangswert zu dem vorbestimmten Satz von Zuordnungen der Referenzdatenstruktur (DR) gehört.

4. Verfahren zum Betreiben nach einem der vorhergehenden Ansprüche, **dadurch gekennzeichnet, dass**
- der Teilschritt (A3_1) des Vorbestimmens der Referenzdatenstruktur (DR) von einer Konfigurationsvorrichtung (15) ausgeführt wird; und
- der Teilschritt (A3_2) des Auswählens von Werten (VGj) der physikalischen Ausgangsgrößen von der zentralen Steuerungseinheit (10) und/oder von den lokalen Steuerungseinheiten (11) ausgeführt wird.

5. Verfahren zum Betreiben nach einem der vorhergehenden Ansprüche, **dadurch gekennzeichnet, dass**
- die Anlage (INST) ferner mindestens einen dritten Sensor umfasst, der geeignet ist, die mindestens eine physikalische Ausgangsgröße (G) an einer Zone (zj) eines Modells des Gebäudes (1) zu messen, wobei die Zone (zj) des Modells ein Bild einer Zone (Zj) des Gebäudes ist;
- das Modell des Gebäudes eine Zuordnung der Lage des mindestens einen dritten Sensors zu einer Lage an einer Zone des Gebäudes (Zj) umfasst;
- der Schritt (A3) des iterativen Bestimmens einen Schritt des Messens der Werte (VGk) der mindestens einen physikalischen Ausgangsgröße (G) an einer Zone (zj) umfasst, wenn der mindestens eine dritte Sensor an dieser Zone positioniert ist.

6. Verfahren zum Betreiben nach einem der vorhergehenden Ansprüche, **dadurch gekennzeichnet, dass**
- die Anlage (INST) ferner mindestens einen zweiten Sensor (23) umfasst, der geeignet ist, die mindestens eine physikalische Ausgangsgröße (G) an einer Zone (Zj) des Gebäudes (1) zu messen;
- das Modell des Gebäudes die Lage des mindestens einen zweiten Sensors (23) in Bezug auf die Zonen des Gebäudes (Zj) umfasst;
- der Schritt (A3) des iterativen Bestimmens einen Schritt des Messens der Werte (VGk) der mindestens einen physikalischen Ausgangsgröße (G) an einer Zone (zj) umfasst, wenn der mindestens eine zweite Sensor (23) an dieser Zone positioniert ist.

7. Verfahren zum Betreiben nach einem der Ansprüche 1 bis 6, **dadurch gekennzeichnet, dass** der Schritt des Verwendens (A8) darin besteht, die bestimmten Werte (VGj) der zentralen Steuerungseinheit (10) und/oder lokalen Steuerungseinheiten (11) bereitzustellen, die dafür zuständig sind, Befehle an elektrische Ausrüstungen (EEi), mit denen jede Zone (Zj) des Gebäudes ausgestattet ist, zu erzeugen und/oder zu senden, insbesondere in Form von Datenströmen.

8. Verfahren zum Betreiben nach einem der Ansprüche 1 bis 6, **dadurch gekennzeichnet, dass** der Schritt des Verwendens (A8) einen Schritt des Auswählens von Werten von Parametern (Pj) zur Steuerung der elektrischen Ausrüstungen (EEi) aus einer zweiten Referenzdatenstruktur (DR2) umfasst, die für jede Zone (Zj) einen vorbestimmten Satz von Zuordnungen ({VGj, Pj}) umfasst zwischen
- vorgegebenen Werten der physikalischen Ausgangsgröße (VGj); und
- vorgegebenen Werten der Parameter (Pj),
wobei die ausgewählten Werte der Parameter die vorgegebenen Werte sind, die in der zweiten Referenzdatenstruktur (DR2) den bestimmten Werten (VGj) zugeordnet sind.

9. Verfahren zum Betrieben nach einem der vorhergehenden Ansprüche, **dadurch gekennzeichnet, dass** der Schritt (A8) des Verwendens umfasst:
- einen Schritt (A6) des Steuerns einer Bewegung jedes motorisierten Sonnenschutzschirms einer ersten Zone (Zj) einer Fassade in Abhängigkeit von einer Information über das Vorhandensein von Sonne für die erste Zone (Zj) einer Fassade,
- einen Schritt (A7) des Deaktivierens des Steuerns einer Bewegung des vorhergehenden Schritts in Abhängigkeit von den Daten der Konfigurationsdatei für jede Öffnung der Zone.

10. Verfahren zum Betreiben nach Anspruch 9, **dadurch gekennzeichnet, dass** der Schritt des Deaktivierens von einer Information über die Sonneneinstrahlungsstärke abhängt.

11. Verfahren zum Betreiben nach einem der vorhergehenden Ansprüche, **dadurch gekennzeichnet**
- **dass** es ferner einen Schritt (A2) des virtuellen Modellierens der umgebenden Strukturen des Gebäudes umfasst und
- **dass** der Schritt (A3) des iterativen Bestimmens auch in Abhängigkeit von dem Ergebnis dieser virtuellen Modellierung der umgebenden Strukturen des Gebäudes durchgeführt wird.

12. Verfahren zum Betreiben nach einem der vorhergehenden Ansprüche, **dadurch gekennzeichnet, dass** die Modellierung des Schritts (A1) eine virtuelle dreidimensionale Modellierung des Gebäudes ist, welche die Lage der Fassaden (N1, N2, S1, S2, W1, W2, E1, E2) und die Anordnung der mit motorisierten Sonnenschutzschirmen ausgestatteten Öffnungen an den Fassaden beinhaltet.

13. Verfahren zum Betreiben nach einem der vorhergehenden Ansprüche, **dadurch gekennzeichnet dass** ein Schritt des iterativen Bestimmens der Schattenwürfe durch das Gebäude auf sich selbst und/oder durch die umgebenden Strukturen, die ebenfalls in Abhängigkeit von der Zeit und für eine gegebene geografische Lage des Gebäudes modelliert werden, je Fassade ausgeführt werden kann und für jede Fassade des Gebäudes wiederholt werden kann, für die eine Information über das Vorliegen von Sonne oder direkten Energiefluss oder direkten Lichtfluss bereitgestellt wird.

14. Anlage (INST) zur automatisierten Steuerung der Komfortbedingungen in einem Gebäude (1), die Anlage (INST) umfassend eine zentrale Steuerungseinheit (10), elektrische Ausrüstungen (EEi), mit denen Zonen (Zj) des Gebäudes ausgestattet sind, und eine Sensorenverwaltungseinheit (30), die mindestens einen Sensor (13) umfasst, der geeignet ist, eine physikalische Eingangsgröße (F) zu messen, **dadurch gekennzeichnet, dass** sie Hardware- und/oder Softwareelemente (10; 11; 13; 15; 30) zur Ausführung des Verfahrens nach einem der vorhergehenden Ansprüche umfasst, wobei die Hardware- und/oder Softwareelemente umfassen:
- ein Element (101) zur Erfassung von Modellierungsdaten des Gebäudes (1) und der Zonen (Zj) des Gebäudes oder ein Element (101) zur Speicherung von Modellierungsspeicherdaten des Gebäudes (1) und der Zonen (Zj) des Gebäudes,
- ein Element (103) zur iterativen Bestimmung von Werten (VGj) mindestens einer physikalischen Ausgangsgröße (G) in Abhängigkeit von mindestens einem Wert (Vf) der physikalischen Eingangsgröße und von dem Modell des Gebäudes (1),
- ein Element (10; 11), das bestimmte Werte (VGj) verwendet, um die elektrischen Ausrüstungen (EEi), mit denen jede Zone (Zj) des Gebäudes ausgestattet ist, zu steuern,
wobei die Anlage zur Ausführung der folgenden Schritte ausgestaltet ist:
- einen Schritt (A1) des Modellierens des Gebäudes (1), der Zonen (Zj) des Gebäudes und von Öffnungen des Gebäudes,
- einen Schritt (A2_1) des Erhaltens mindestens eines ersten Werts (Vm) der physikalischen Eingangsgröße (F), der von dem mindestens einen Sensor (13) gemessen wird, Messwert genannt, wobei die physikalische Eingangsgröße (F) eine Uhrzeit ist,
- einen Schritt (A3) des Bestimmens von Werten (VGj) von physikalischen Ausgangsgrößen (G) in Abhängigkeit von dem ersten Wert (Vm) der physikalischen Eingangsgröße (F), von dem Modell des Gebäudes (1), von den Zonen (Zj) des Gebäudes und von den Öffnungen des Gebäudes,
wobei der Schritt (A3) des Bestimmens umfasst:
einen Teilschritt (A3_1) des Vorbestimmens einer Referenzdatenstruktur (DR), die Werte (VGj) der physikalischen Ausgangsgrößen umfasst, die für eine Vielzahl von Werten der physikalischen Eingangsgröße berechnet werden, wobei der Teilschritt (A3_1) des Vorbestimmens das iterative Bestimmen der Werte (VGj) der physikalischen Ausgangsgrößen (G) umfasst, das durch eine Simulation des Laufs der Sonne im Laufe der Zeit und unter Berücksichtigung des Einflusses der Strukturen, die sich auf den Bahnen der simulierten Sonnenstrahlen befinden, ausgeführt wird, wobei das iterative Bestimmen von Werten (VGj) für eine gegebene geographische Lage des Gebäudes ausgeführt wird, wobei die physikalischen Ausgangsgrößen (G) direkte Sonnenenergieflüsse an jeder Zone (Zj) des Gebäudes sind, und
einen Teilschritt (A3_2) des Auswählens der Werte der physikalischen Ausgangsgrößen in dieser Referenzdatenstruktur in Abhängigkeit von dem mindestens einen ersten Wert (Vm), und
- einen Schritt (A8) des Verwendens der bestimmten Werte (VGj), um die elektrischen Ausrüstungen (EEi) zu steuern, mit denen jede Zone (Zj) des Gebäudes ausgestattet ist, wobei die elektrische Ausrüstung, mit der eine Zone ausgestattet ist, durch die für diese Zone bestimmten Werte gesteuert wird, wobei der Schritt des Verwendens eine Bereitstellung von Werten für die zentrale Steuerungseinheit und/oder für lokale Steuerungseinheiten umfasst, die dafür zuständig sind, Befehle an die elektrischen Ausrüstungen, mit denen jede Zone des Gebäudes ausgestattet ist, zu erzeugen und/oder zu senden.

## Claims

1. Method for operating an installation (INST) for the automated control of the comfort conditions in a building (1), the installation (INST) comprising a central control unit (10), electrical equipment items (EEi) with which areas (Zj) of the building are equipped, and a sensor management unit (30) comprising at least one sensor (13) suitable for measuring an input physical quantity (F), the method being **characterized in that** it comprises the following steps implemented by the installation:
- A step (A1) of modelling the building (1), the areas (Zj) of the building and openings of the building,
- A step (A2_1) of obtaining at least one first value (Vm) of the input physical quantity (F) measured by the at least one sensor (13), called measured value, the input physical quantity (F) being a chronological time,
- A step (A3) of determining values (VGj) of output physical quantities (G), as a function of the first value (Vm) of the input physical quantity (F), of the model of the building (1), of the areas (Zj) of the building and of the openings of the building,
the determination step (A3) comprising:
a substep (A3_1) of predetermining a reference data structure (DR) comprising values (VGj) of the output physical quantities computed for a plurality of values of the input physical quantity, the predetermination substep (A3_1) comprising iteratively determining the values (VGj) of the output physical quantities (G) by simulating the course of the sun over time and by taking into account the impact of the structures located on the trajectories of the simulated sun rays, said iterative determination of values (VGj) being done for a given geographic location of the building, the output physical quantities (G) being direct solar energy fluxes in each area (Zj) of the building, and
a substep (A3_2) of selecting values of the output physical quantities in this reference data structure, as a function of the at least one first value (Vm), and
- A step (A8) of using the determined values (VGj) in order to control the electrical equipment items (EEi) with which each area (Zj) of the building is equipped, the electrical equipment item with which an area is equipped being controlled by the values determined for this area, the usage step comprising supplying values to the central control unit and/or to local control units responsible for generating and/or sending commands to the electrical equipment items with which each area of the building is equipped.

2. Operating method according to Claim 1, **characterized in that** the iterative determination step (A3) comprises a step of determining, notably by computation, values (VGj) of the at least one output physical quantity (G), for at least two areas (Zj) of the building.

3. Operating method according to one of the preceding claims, **characterized in that** the reference data structure (DR) comprises, for each area (Zj), a predetermined set of associations ({Vrk, VGj}) between
- representative predefined values (Vrk) of ranges of values of the input physical quantity (F); and
- representative predefined values (VGj) of ranges of values of the output physical quantity (G);
the selection substep (A3_2) comprising
- a substep of determining a representative value (Vrm) of the first value (Vm), called input value;
- a substep of determining a predefined value (VGm) of the output physical quantity (G), called output value, such that the association {Vrm, VGm} between input value and output value belongs to the predetermined set of associations of the reference data structure (DR).

4. Operating method according to one of the preceding claims, **characterized in that**
- the substep (A3_1) of predetermining the reference data structure (DR) is executed by a configuration device (15); and
- the substep (A3_2) of selecting values (VGj) of the output physical quantities is executed by the central control unit (10) and/or by the local control units (11).

5. Operating method according to one of the preceding claims, **characterized in that**
- the installation (INST) also comprises at least one third sensor suitable for measuring the at least one output physical quantity (G) in an area (zj) of a model of the building (1), the area (zj) of the model being an image of an area (Zj) of the building;
- the model of the building comprises an association of the location of the at least one third sensor with a location in an area of the building (Zj);
- the iterative determination step (A3) comprises a step of measuring the values (VGk) of the at least one output physical quantity (G) in an area (zj) if the at least one third sensor is located **in that** area.

6. Operating method according to one of the preceding claims, **characterized in that**
- the installation (INST) also comprises at least one second sensor (23) suitable for measuring the at least one output physical quantity (G) in an area (Zj) of the building (1);
- the model of the building comprises the location of the at least one second sensor (23) relative to the areas of the building (Zj);
- the iterative determination step (A3) comprises a step of measuring the values (VGk) of the at least one output physical quantity (G) in an area (Zj) if the at least one second sensor (23) is located **in that** area.

7. Operating method according to one of Claims 1 to 6, **characterized in that** the usage step (A8) consists in supplying the determined values (VGj) to the central control unit (10) and/or to local control units (11) responsible for generating and/or sending commands to electrical equipment items (EEi) with which each area (Zj) of the building is equipped, notably in data stream form.

8. Operating method according to one of Claims 1 to 6, **characterized in that** the usage step (A8) comprises a step of selecting parameter values (Pj) for the control of the electrical equipment items (EEi), in a second reference data structure (DR2) comprising, for each area (Zj), a predetermined set of associations ({VGj, Pj}) between
- predefined values of the output physical quantity (VGj); and
- predefined values of the parameters (Pj),
the selected values of the parameters being the predefined values associated in the second reference data structure (DR2) with the determined values (VGj).

9. Operating method according to one of the preceding claims, **characterized in that** the usage step (A8) comprises:
- A step (A6) of commanding a movement of each motorized solar protection screen of a first façade area (Zj) as a function of a sun presence indication relating to the first façade area (Zj),
- A step (A7) of disabling the command of movement of the preceding step as a function of the configuration file data relating to each opening of the area.

10. Operating method according to Claim 9, **characterized in that** the disabling step depends on a sunshine level indication.

11. Operating method according to one of the preceding claims, **characterized**
- **in that** it also comprises a step (A2) of virtual modelling of the structures surrounding the building, and
- **in that** the iterative determination step (A3) is performed also as a function of the result of this virtual modelling of the structures surrounding the building.

12. Operating method according to one of the preceding claims, **characterized in that** the modelling of the step (A1) is a three-dimensional virtual modelling of the building, including the location of the façades (N1, N2, S1, S2, W1, W2, E1, E2) and the positioning of the openings equipped with motorized solar protection screens on the façades.

13. Operating method according to one of the preceding claims, **characterized in that** a step of iteratively determining the shadows cast by the building on itself and/or by the surrounding structures also modelled as a function of time and for a given geographic location of the building may be performed for each façade and reiterated for each façade of the building for which a sun presence or direct energy flux or direct light flux indication is supplied.

14. Automated control installation (INST) for controlling the comfort conditions in a building (1), the installation (INST) comprising a central control unit (10), electrical equipment items (EEi) with which areas (Zj) of the building are equipped and a sensor management unit (30) comprising at least one sensor (13) suitable for measuring an input physical quantity (F), **characterized in that** it comprises hardware and/or software elements (10; 11; 13; 15; 30) for implementing the method according to one of the preceding claims, the hardware and/or software elements comprising:
- an element (101) for entering modelling data for the building (1) and for the areas (Zj) of the building or a data storage element (101) for storing a modelling of the building (1) and of the areas (Zj) of the building,
- an element (103) for iteratively determining values (VGj) of at least one output physical quantity (G), as a function of at least one value (Vf) of the input physical quantity and of the model of the building (1),
- an element (10; 11) using determined values (VGj) in order to control the electrical equipment items (EEi) with which each area (Zj) of the building is equipped, the installation being configured to implement the following steps:
- A step (A1) of modelling the building (1), the areas (Zj) of the building and openings of the building,
- A step (A2_1) of obtaining at least one first value (Vm) of the input physical quantity (F) measured by the at least one sensor (13), called measured value, the input physical quantity (F) being a chronological time,
- A step (A3) of determining values (VGj) of output physical quantities (G), as a function of the first value (Vm) of the input physical quantity (F), of the model of the building (1), of the areas (Zj) of the building and of the openings of the building,
the determination step (A3) comprising:
a substep (A3_1) of predetermining a reference data structure (DR) comprising values (VGj) of the output physical quantities computed for a plurality of values of the input physical quantity, the predetermination substep (A3_1) comprising iteratively determining the values (VGj) of the output physical quantities (G) by simulating the course of the sun over time and by taking into account the impact of the structures located on the trajectories of the simulated sun rays, said iterative determination of values (VGj) being done for a given geographic location of the building, the output physical quantities (G) being direct solar energy fluxes in each area (Zj) of the building, and
a substep (A3_2) of selecting values of the output physical quantities in this reference data structure, as a function of the at least one first value (Vm), and
- A step (A8) of using the determined values (VGj) in order to control the electrical equipment items (EEi) with which each area (Zj) of the building is equipped, the electrical equipment item with which an area is equipped being controlled by the values determined for this area, the usage step comprising supplying values to the central control unit and/or to local control units responsible for generating and/or sending commands to the electrical equipment items with which each area of the building is equipped.
